# EUROPÄISCHE PATENTANMELDUNG

(11) **EP 4 019 164 A1**
(43) Veröffentlichungstag der Anmeldung: **29.06.2022**
(21) Anmeldenummer: 20216448.9
(22) Anmeldetag: 22.12.2020
(51) Int. Cl.: B22F 5/00, B22F 10/366, B33Y 10/00, B33Y 50/02, B22F 10/20, B22F 10/80, B22F 10/85, B33Y 50/00, B22F 10/368

(54) **BESTRAHLUNGSSTRATEGIE IN DER ADDITIVEN HERSTELLUNG MIT GEPULSTER BESTRAHLUNG**

(71) Anmelder: Siemens Energy Global GmbH & Co. KG, 81739 München (DE)
(72) Erfinder: Heitmann, Timo, 10245 Berlin (DE); Bogner, Jan Pascal, 13357 Berlin (DE); Geisen, Ole, 14057 Berlin (DE)

(57) **Zusammenfassung**

Es wird ein Verfahren zur pulverbett-basierten, additiven Herstellung eines Bauteils (10) angegeben, umfassend das Festlegen von Bestrahlungsvektoren (Vh, Vc) für eine zu bestrahlende Schicht (L) für das Bauteil (10), wobei Bestrahlungsvektoren (Vh, Vc) unterhalb einer Länge von 1 mm in einem gepulsten Bestrahlungsbetrieb (pw) bestrahlt werden, wobei eine Pulsfrequenz unterhalb von 3 kHz und eine Scangeschwindigkeit unterhalb von 250 mm/s gewählt werden. Weiterhin werden ein entsprechend hergestelltes Bauteil, ein zugehöriges Verfahren zum Bereitstellen von Herstellungsanweisungen und ein zugehöriges Computerprogrammprodukt angegeben.

## Beschreibung

Die vorliegende Erfindung betrifft ein Verfahren zur pulverbett-basierten, additiven Herstellung eines Bauteils bzw. ein entsprechendes (computerimplementiertes) Verfahren zum Bereitstellen von Herstellungsanweisungen, beispielsweise im Wege des "Computer-Aided-Manufacturing". Weiterhin werden ein entsprechend hergestelltes Bauteil sowie ein zugehöriges Computerprogramm(produkt) angegeben.

Das Bauteil ist vorzugsweise für den Einsatz im Heißgaspfad einer Gasturbine vorgesehen. Beispielsweise betrifft das Bauteil eine zu kühlende Komponente mit einem dünnwandigen oder filigranen Design. Alternativ oder zusätzlich kann es sich bei dem Bauteil um eine Komponente für den Einsatz in der Automobilität oder im Luftfahrtsektor handeln.

Performante Maschinenkomponenten sind Gegenstand stetiger Verbesserung, um insbesondere ihre Effizienz im Einsatz zu steigern. Bei Wärmekraftmaschinen, insbesondere Gasturbinen, führt dies allerdings unter anderem zu immer höheren Einsatztemperaturen. Die metallischen Materialien und das Komponentendesign hochbelastbarer Bauteile, wie Turbinenlaufschaufeln, insbesondere in den ersten Stufen, werden ständig hinsichtlich ihrer Festigkeit, Lebensdauer, Kriechbelastbarkeit und thermomechanischer Ermüdung, verbessert.

Die generative oder additive Fertigung wird aufgrund ihres für die Industrie disruptiven Potenzials zunehmend interessant auch für die Serienherstellung der oben genannten Bauteile, wie beispielsweise Turbinenschaufeln oder Brennerkomponenten.

Additive Herstellungsverfahren (AM: "additive manufacturing"), umgangssprachlich auch als 3D-Druck bezeichnet, umfassen beispielsweise als Pulverbettverfahren das selektive Laserschmelzen (SLM) oder Lasersintern (SLS), oder das Elektronenstrahlschmelzen (EBM).

Ein Verfahren zum selektiven Laserschmelzen mit gepulster Bestrahlung ist beispielsweise bekannt aus EP 3 022 008 B1.

Additive Fertigungsverfahren haben sich weiterhin als besonders vorteilhaft für komplexe oder filigran gestaltete Bauteile, beispielsweise labyrinthartige Strukturen, Kühlstrukturen und/oder Leichtbau-Strukturen erwiesen. Insbesondere ist die additive Fertigung durch eine besonders kurze Kette von Prozessschritten vorteilhaft, da ein Herstellungs- oder Fertigungsschritt eines Bauteils weitgehend auf Basis einer entsprechenden CAD-Datei und der Wahl entsprechender Fertigungsparameter erfolgen kann.

Die Herstellung von Gasturbinenschaufeln mittels der beschriebenen pulverbett-basierten Verfahren (LPBF englisch für "Laser Powder Bed Fusion") ermöglicht vorteilhaft die Implementierung von neuen Geometrien, Konzepten, Lösungen und/oder Design, welche die Herstellungskosten bzw. die Aufbau- und Durchlaufzeit reduzieren, den Herstellungsprozess optimieren und beispielsweise eine thermo-mechanische Auslegung oder Strapazierfähigkeit der Komponenten verbessern können.

Auf konventionelle Art, beispielsweise gusstechnisch, hergestellte Komponenten, stehen der additiven Fertigungsroute beispielsweise hinsichtlich ihrer Formgebungsfreiheit und auch in Bezug auf die erforderliche Durchlaufzeit und den damit verbundenen hohen Kosten sowie dem fertigungstechnischen Aufwand deutlich nach.

Das liegt daran, dass durch den Pulverbettprozess in der Bauteilstruktur inhärent hohe thermische Spannungen induziert werden. Insbesondere führen zu kurz bemessene Bestrahlungswege oder -vektoren zu stärken Überhitzungen, die wiederum zum Verzug der Struktur führen. Ein starker Verzug während des Aufbauprozesses führt daher leicht zu strukturellen Ablösungen, thermischen Verformungen oder geometrischen Abweichungen außerhalb einer zulässigen Toleranz.

Konventionelle Lösungsmöglichkeiten für diese Problematik sind die Verbesserung der Wärmeabfuhr über eine Bauplatte oder ein Aufbausubstrat, da das Pulverbett thermisch quasi isolierend ist. Weiterhin könnte das Problem dadurch umgangen werden, dass man filigrane Bauteilbereiche oder dünnwandige Abschnitte, die besonders zu thermischen Verzügen neigen, von vornherein nicht vorsieht.

Weiterhin besteht die Möglichkeit der Anpassung einer Bestrahlungsstrategie oder Scanstrategie, insbesondere der Verlängerung von entsprechenden Bestrahlungvektoren, insbesondere Schraffurbestrahlungsvektoren, womit eine Abkühlzeit des entsprechend bestrahlten Pulvers vergrößert und die thermische Belastung reduziert werden kann. Dies impliziert jedoch möglicherweise, dass dünnwandige Abschnitte nicht realisiert werden können. Alternativ kann der räumlich oder zeitlich eingebrachte Wärmeeintrag durch sogenanntes "skywriting" reduziert werden, wobei Vektoren einer rasterartigen Bestrahlung nur gedanklich verlängert werden bzw. eine Energiestrahl, wie ein Laser oder Elektronenstrahl, während des Bestrahlungsvorgangs ausgeschaltet wird. Effektiv wird so ebenfalls die Abkühlzeit verlängert. Durch diese Ansätze wird aber auch die Prozesseffizienz beeinträchtigt. Mit anderen Worten dauert der Herstellungsprozess pro bestrahlter Schicht deutlich länger, was Kosten in der Maschinenbelegung verursacht.

Es ist daher eine Aufgabe der vorliegenden Erfindung, Mittel anzugeben, mit denen die beschriebenen Probleme gelöst werden können, insbesondere Mittel für ein verbessertes Wärmemanagement, bei der selektiven Bestrahlung.

Diese Aufgabe wird durch den Gegenstand der unabhängigen Patentansprüche gelöst. Vorteilhafte Ausgestaltungen sind Gegenstand der abhängigen Patentansprüche.

Ein Aspekt der vorliegenden Erfindung betrifft ein Verfahren zur pulverbett-basierten, additiven Herstellung eines Bauteils, umfassend das Festlegen von Bestrahlungsvektoren für eine selektiv, beispielsweise über SLM oder EBM zu bestrahlende Schicht (Pulverschicht) für das Bauteil, wobei Bestrahlungsvektoren mit einer Länge unterhalb von etwa 1 mm in einem gepulsten Bestrahlungsbetrieb bestrahlt werden, wobei eine Pulsfrequenz unterhalb von 3 kHz und eine Raster-oder Scangeschwindigkeit unterhalb von 250 mm/s gewählt und/oder eingestellt werden. Dabei werden die beschriebenen Parameter vorzugsweise tatsächlich auf einzelne Bestrahlungsvektoren und nicht nur auf die jeweilige zu bestrahlende Schicht als Ganzes angewendet.

Mit Vorteil kann ein Wärmeeintrag in das Pulvermaterial durch die beschriebenen Mittel während der Herstellung des Bauteils maßgeschneidert bzw. angepasst werden, so dass weiterhin eine ausreichende Zeit zum Abkühlen einzelner Schmelzbäder, welche aus der selektiven Bestrahlung der genannten Bestrahlungsvektoren hervorgehen, vorgesehen wird. Dies führt gleichsam zu reproduzierbaren Strukturergebnissen für die entsprechenden Bauteilschichten, und zur Vermeidung von übermäßigem thermischen Verzug und/oder Rissneigung.

In einer Ausgestaltung sind die Bestrahlungsvektoren Schraffurbestrahlungsvektoren. Dieser Art der Vektoren betreffen den Hauptanteil der zu bestrahlenden Flächen einer jeweiligen Bauteilschicht, dessen Verfestigung anschließend möglicherweise nur noch durch sogenannte Konturbestrahlung (Konturbestrahlungsvektoren) zu vervollständigen ist.

In einer Ausgestaltung werden Bestrahlungsvektoren zwischen 1 mm und 2 mm Länge ebenfalls in einem gepulsten Bestrahlungsbetrieb bestrahlt, wobei abweichend jedoch eine Pulsfrequenz oberhalb von 3 kHz und eine Scangeschwindigkeit oberhalb von 250 mm/s gewählt werden. Diese Ausgestaltung erlaubt es ebenfalls vorteilhaft, die erfindungsgemäßen Vorteile umzusetzen, da auch in diesem Längenbereich ein übermäßiger Wärmeeintrag zu einem schlechten Strukturergebnis (siehe oben) führen kann. Insbesondere können gemäß dieser Ausgestaltung für einen entsprechend zu bestrahlenden Pulverbereich höhere Scangeschwindigkeiten nämlich > 250mm/s genutzt werden, dies gegebenenfalls bei gleichem Schraffurabstand. Dies ermöglicht weiterhin - im Vergleich zu der niederfrequenteren und langsamer gerasterten Bestrahlung eine Steigerung der Produktivität bei geringerer Energiezufuhr und entsprechend reduzierten Überhitzungen ("hot spots") in der Struktur des Bauteils.

Weiterhin können durch die genannte Ausgestaltung, wobei gemäß einer kritischen Vektorlänge unterhalb von 1 mm ein niederfrequenter Pulsbetrieb und/oder ab oder oberhalb von 1 mm ein höherfrequenter Pulsbetrieb gewählt wird, auf die Geometrie einzelner Bauteilabschnitte ideal abgestimmter Bestrahlungsparametersatz vorgegeben werden, der den additiven Aufbau von dünnwandigen Strukturen überhaupt erst ermöglicht. Da üblicherweise für Überhitzungen weniger anfällige Bauteilabschnitte ein kontinuierlicher Bestrahlungsbetrieb gewählt wird, kombiniert die vorliegende Erfindung gegebenenfalls vorteilhaft den üblichen Dauerstrichbetrieb mit dem gepulsten Bestrahlungsbetrieb für verbesserte Bauteileigenschaften.

In einer Ausgestaltung wird ein Schraffurabstand der Bestrahlungsvektoren derart gewählt, dass ein Überlapp von direkt benachbarten Bestrahlungsvektoren entsprechenden Schmelzbädern zwischen 30 % und 50 % einer Schmelzbadbreite beträgt. Durch den so bemessenen Überlapp wird einerseits auf zweckmäßige Art eine flächendeckende Schichtbestrahlung erreicht und, andererseits, der Überlapp der Schmelzbäder bzw. der Abstand der Bestrahlungsvektoren vorteilhaft auf den gepulsten Bestrahlungsbetrieb angepasst. Diese Ausgestaltung ist vorteilhaft sowohl für Bestrahlungsvektoren unterhalb von 1 mm Länge als auch für solche in einem Bereich zwischen 1 mm und 2 mm Länge.

In einer Ausgestaltung werden Bestrahlungsvektoren ab oder oberhalb einer Länge von ca. 2 mm in einem kontinuierlichen Bestrahlungsbetrieb bzw. Dauerstrichbetrieb bestrahlt. Wie für alle vorliegend beschriebenen Ausgestaltungen erfolgt die Bestrahlung zweckmäßigerweise selektiv entweder durch einen Laserstrahl oder einen Elektronenstrahl im Wege des additiven Herstellungsprozesses.

Ein weiterer Aspekt der vorliegenden Erfindung betrifft ein Bauteil, welches gemäß dem beschriebenen Verfahren herstellbar oder hergestellt ist, wobei das Bauteil für den Einsatz im Heißgaspfad einer Strömungsmaschine, insbesondere einer stationären Gasturbine, vorgesehen ist und mindestens einen dünnwandigen Abschnitt aufweist, beispielsweise ein Abschnitt, welcher besonders anfällig für thermischen Verzug ist.

Ein weiterer Aspekt der vorliegenden Erfindung betrifft ein computerimplementiertes Verfahren zum Bereitstellen von Herstellungsanweisungen für die additive Herstellung eines Bauteils, umfassend das Festlegen von Bestrahlungsparametern, insbesondere das Einstellen der beschriebenen Pulsfrequenz und Scangeschwindigkeit im gepulsten Bestrahlungsbetrieb (siehe oben).

In einer Ausgestaltung ist das computerimplementierte Verfahren ein CAM-Verfahren ("Computer-Aided-Manufacturing") oder ein Teil davon.

Ein weiterer Aspekt der vorliegenden Erfindung betrifft ein Computerprogramm bzw. Computerprogrammprodukt, umfassend Befehle, die bei der Ausführung eines entsprechenden Programms durch einen Computer, eine Datenverarbeitungseinrichtung oder eine Steuerungsvorrichtung für die Bestrahlung in einer additiven Herstellungsanlage, diese Mittel veranlassen, die Bestrahlungsparameter wie oben beschrieben festzulegen und/oder einzustellen.

Eine CAD-Datei oder ein Computerprogrammprodukt, kann beispielsweise als (flüchtiges oder nicht-flüchtiges) Speichermedium, wie z.B. eine Speicherkarte, ein USB-Stick, eine CD-ROM oder DVD, oder auch in Form einer herunterladbaren Datei von einem Server und/oder in einem Netzwerk bereitgestellt oder umfasst werden. Die Bereitstellung kann weiterhin zum Beispiel in einem drahtlosen Kommunikationsnetzwerk durch die Übertragung einer entsprechenden Datei mit dem Computerprogrammprodukt erfolgen. Ein Computerprogrammprodukt kann Programmcode, Maschinencode bzw. numerische Steuerungsanweisungen, wie G-code und/oder andere ausführbare Programmanweisungen im Allgemeinen beinhalten.

Das Computerprogrammprodukt kann weiterhin Geometriedaten oder Konstruktionsdaten in einem dreidimensionalen Format bzw. als CAD-Daten enthalten bzw. ein Programm oder Programmcode zum Bereitstellen dieser Daten umfassen.

Ausgestaltungen, Merkmale und/oder Vorteile, die sich vorliegend auf das oder die Verfahren bzw. das Computerprogrammprodukt beziehen, können ferner das Bauteil selbst betreffen, und umgekehrt.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elemente verwendet werden.

Weitere Einzelheiten der Erfindung werden nachfolgend anhand der Figuren beschrieben.
Figur 1 zeigt eine Prinzipdarstellung eines pulverbett-basierten, additiven Herstellungsprozesses.
Figur 2 zeigt eine schematische perspektivische Ansicht eines Bauteilbereichs.
Figur 3 deutet anhand einer schematischen Aufsicht bzw. Querschnittsansicht einer zu bestrahlenden Schicht für ein Bauteil erfindungsgemäße Verfahrensschritte an.
Figur 4 deutet anhand einer schematischen Aufsicht bzw. Querschnittsansicht einer zu bestrahlenden Schicht für ein Bauteil erfindungsgemäße Verfahrensschritte an.

In den Ausführungsbeispielen und Figuren können gleiche oder gleichwirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis übertrieben dick oder groß dimensioniert dargestellt sein.

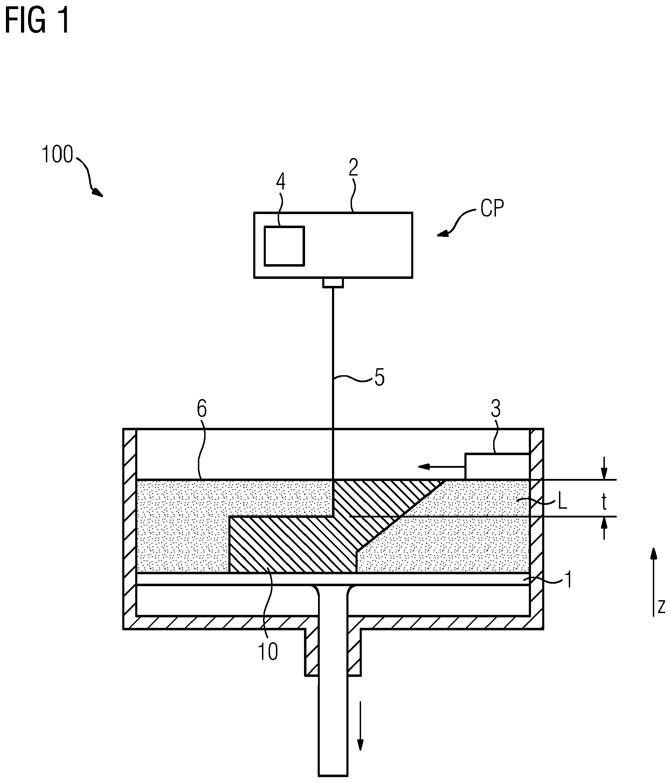

Figur 1 zeigt eine additive Herstellungsanlage 100. Die Herstellungsanlage 100 ist vorzugsweise als LPBF-Anlage und für den additiven Aufbau von Bauteilen oder Komponenten aus einem Pulverbett ausgestaltet. Die Anlage 100 kann im Speziellen auch eine Anlage zum Elektronenstrahlschmelzen betreffen.

Demgemäß weist die Anlage eine Bauplattform 1 auf. Auf der Bauplattform 1 wird ein additiv herzustellendes Bauteil 10 schichtweise hergestellt. Das Pulverbett wird durch ein Pulver 6 gebildet, welches durch eine Beschichtungseinrichtung 3 schichtweise auf der Bauplattform 1 verteilt werden kann.

Nach dem Auftragen einer jeden Pulverschicht L - üblicherweise mit einer voreingestellten Schichtdicke t - werden gemäß der vorgegebenen Geometrie des Bauteils 10 selektiv Bereiche der Schicht L mit einem Energiestrahl 5, beispielsweise einem Laser oder Elektronenstrahl, von einer Bestrahlungseinrichtung 2 aufgeschmolzen und anschließend verfestigt.

Nach jeder Schicht L wird die Bauplattform 1 vorzugsweise um ein der Schichtdicke L entsprechendes Maß abgesenkt (vergleiche nach unten gerichteten Pfeil in Figur 1). Die Dicke t beträgt üblicherweise lediglich zwischen 20 µm und 80 µm, vorzugsweise 40 µm, so dass der gesamte Prozess leicht eine Bestrahlung von Zehntausenden von Schichten umfassen kann.

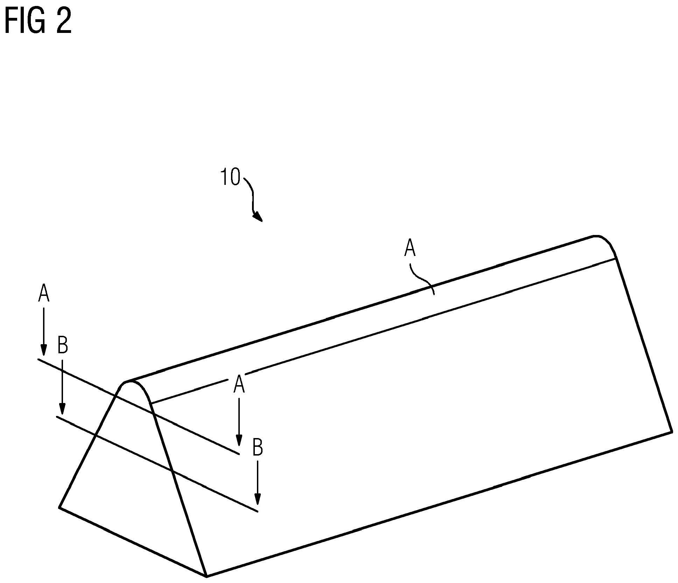

Dabei können durch den lediglich sehr lokal wirkenden Energieeintrag weiterhin hohe Temperaturgradienten, von beispielsweise 10⁶ K/s oder mehr auftreten. Dementsprechend groß ist selbstverständlich während des Aufbaus und danach auch ein Verspannungszustand des Bauteils, was die additiven Herstellungsprozesse erheblich verkompliziert. Solche Verspannungszustände sind umso kritischer, je filigraner oder dünnwandiger ein Bauteilbereich (vergleiche Figur 2 weiter unten) ausgestaltet werden soll, da die Verspannung dann zu starkem geometrischen Verzug, Rissneigung oder sogar zur Zerstörung des Bauteils führen kann.

Die Geometrie des Bauteils wird üblicherweise durch eine CAD-Datei ("Computer-Aided-Design") festgelegt. Nach dem Einlesen einer solchen Datei in die Herstellungsanlage 100 erfordert der Prozess anschließend zunächst die Festlegung einer geeigneten Bestrahlungsstrategie beispielsweise durch Mittel des CAM, wodurch auch ein Aufteilen der Bauteilgeometrie in die einzelnen Schichten erfolgt. Die Bestrahlungsstrategie umfasst üblicherweise die Festlegung einer Vielzahl von Bestrahlungs- oder Aufbauparametern, wie vorliegend weiter ausgeführt ist.

Es ist ersichtlich, dass die Wahl einer bevorzugten Bestrahlungsstrategie, umfassend die Festlegung wesentlicher Bestrahlungsparameter für den additiven Herstellungsprozess des Bauteils, bereits die erfinderischen Grundgedanken trägt und bei einer simplen Ausführung eines entsprechenden Bestrahlungsvorgangs das Bauteil unweigerlich mit vorteilhaften strukturellen Eigenschaften ausstattet. Mit anderen Worten werden die vorteilhaften technischen Eigenschaften dem Bauteil bereits durch die Festlegung von entsprechenden Bestrahlungsparametern aufgeprägt. Demgemäß ist ein Computerprogramm, Computerprogrammprodukt CP oder ein, ein solches umfassender Datenträger, Teil der vorliegenden Erfindung.

Bei dem Bauteil 10 kann es sich um ein Bauteil einer Strömungsmaschine, beispielsweise um ein Bauteil für den Heißgaspfad einer Gasturbine, handeln. Insbesondere kann das Bauteil eine Lauf- oder Leitschaufel, ein Ringsegment, ein Brennerteil oder eine Brennerspitze, eine Zarge, eine Schirmung, ein Hitzeschild, eine Düse, eine Dichtung, einen Filter, eine Mündung oder Lanze, einen Resonator, einen Stempel oder einen Wirbler bezeichnen, oder einen entsprechenden Übergang, Einsatz, oder ein entsprechendes Nachrüstteil.

Figur 2 zeigt schematisch einen Bauteilbereich, umfassend einen besonders filigranen Abschnitt A, d.h. vorteilhafterweise einen Teil des Bauteils, welcher im Vergleich zu anderen Bauteilabschnitten sehr dünn oder filigran ausgestaltet ist. Wie angedeutet, neigen solche Abschnitte A, unabhängig davon, ob diese tatsächlich eine Spitze des Bauteils oder eine seitliche Wand darstellen, stark zu mechanischen Verzügen und/oder Rissbildung. Solche Verzüge sind der Einfachheit halber in Figur 2 nicht gekennzeichnet.

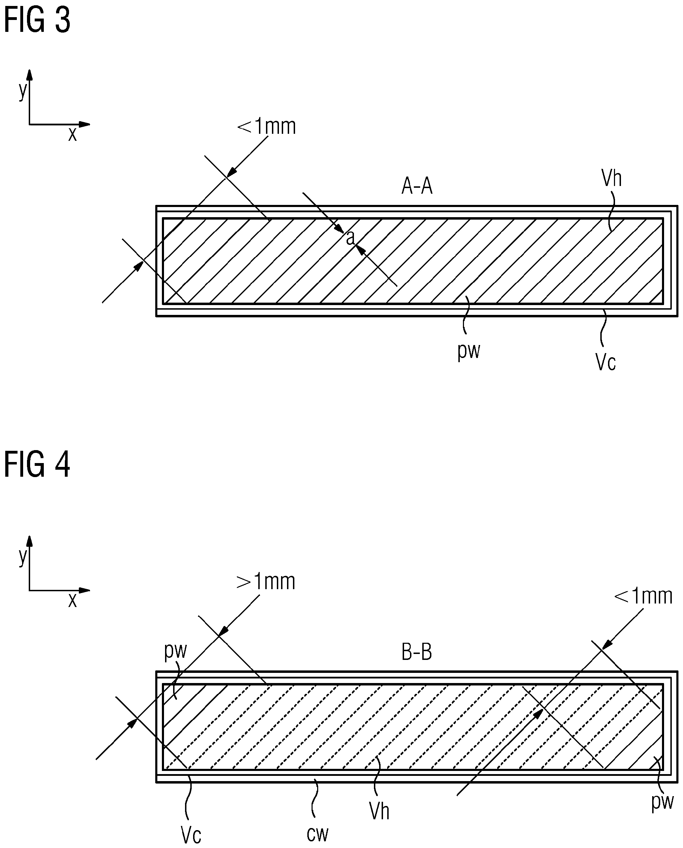

Figur 3 zeigt einen Schnitt bzw. eine Aufsicht auf eine Schicht L entlang der Linie A-A, wie in Figur 2 angedeutet. Entsprechend der relativ kleinen geometrischen Ausdehnung der Schicht bzw. der Bauteilstruktur, wie sie in Figur 3 dargestellt ist, erfordert deren additiver Aufbau insbesondere die Festlegung von relativ kurzen Bestrahlungsvektoren, insbesondere Schraffurbestrahlungsvektoren Vh. Es ist schichtweise im Rahmen solcher Aufbauprozesse nicht immer möglich eine Ausrichtung der Bestrahlungsvektoren unter Berücksichtigung der Bauteilgeometrie vorzunehmen, sodass die Vektorausrichtung zum Teil bereits anderweitig festgelegt oder nicht mehr variabel ist.

Weiterhin sind in der Schnittansicht der Figur 3 Konturbestrahlungsvektoren Vc eingezeichnet, welche die Schraffurbestrahlungsvektoren Vh umranden, beispielsweise um einen Randbereich mit zuverlässiger Strukturgüte zu verfestigen.

Die vorliegende Erfindung schlägt nun ein Verfahren zur pulverbett-basierten, additiven Herstellung des Bauteils 10 vor, gemäß dem Bestrahlungsvektoren für eine entsprechend zu bestrahlende Schicht L derart festgelegt und/oder bestrahlt werden, dass Bestrahlungsvektoren unterhalb einer Länge von 1 mm in einem gepulsten Bestrahlungsbetrieb pw bestrahlt werden, und wobei eine Pulsfrequenz unterhalb von 3 kHz und eine Scangeschwindigkeit unterhalb von 250 mm/s gewählt werden. Dadurch lassen sich wie oben beschrieben die übergebührenden thermischen Verzugs- oder Spannungszustände auf ein Maß reduzieren, dass eine ausreichende Strukturgüte sowie eine hinreichende Maßhaltigkeit des Bauteils gewährleistet. Vorzugsweise handelt es sich bei den genannten Bestrahlungsvektoren um Schraffurbestrahlungsvektoren Vh.

Weiterhin ist in Figur 3 ein Schraffurabstand a der Bestrahlungsvektoren Vh dargestellt, welcher derart gewählt wird, dass ein Überlapp von direkt benachbarten Bestrahlungsvektoren entsprechenden Schmelzbädern zwischen 30 % und 50 % beträgt.

Figur 4 zeigt einen Schnitt bzw. eine Aufsicht auf eine Schicht L entlang der Linie B-B, wie in Figur 2 angedeutet.

Im Gegensatz zu der Darstellung der Figur 3, ist in dieser Schnittansicht kein ganz so dünnwandiger oder filigraner Bereich skizziert, sodass entsprechende Schraffurbestrahlungsvektoren Vh - im Vergleich zu der Darstellung der Figur 3 - etwas länger bemessen werden können, ohne die aufzubauende Struktur thermisch zu überlasten.

Wenngleich die in der Mitte der Schicht gezeigten Vektoren auch mit einem kontinuierlichen Bestrahlungsbetrieb hergestellt werden können, soll in Figur 4 angedeutet werden, dass Bestrahlungsvektoren Vh (vergleiche Ränder links und rechts) beispielsweise auch lediglich eine Länge zwischen 1 mm und 2 mm haben und daher vorzugsweise in einem gepulsten Bestrahlungsbetrieb pw bestrahlt werden, wobei eine Pulsfrequenz f hier vorzugsweise oberhalb von 3 kHz und eine Scangeschwindigkeit v oberhalb von 250 mm/s gewählt werden.

Übersteigt eine (festgelegte) Länge der Bestrahlungsvektoren beispielsweise einen Wert von ca. 2 mm kann auf einen kontinuierlichen Bestrahlungsbetrieb cw zurückgegriffen werden, um den additiven Aufbauprozess beispielsweise zeitlich effizienter durchzuführen.

Die oben genannten Schwellenwerte von 1 mm beziehungsweise 2 mm für die Länge entsprechender Bestrahlungsvektoren, die sich übrigens auch auf die Konturbestrahlungsvektoren Vc beziehen kann, können insbesondere vorteilhaft sein, da Schmelzbadbreiten in dem beschriebenen Kontext zweckmäßigerweise zwischen 200 µm und 500 µm betragen, und das Pulvermaterial aufgrund der Bestrahlung eines gegebenen Vektors möglicherweise nicht vollständig erstarrt, bevor der nächstliegende (benachbarte) Vektor belichtet oder bestrahlt wird.

Die beschriebenen Mittel erlauben es vorteilhafterweise insbesondere durch die Abstimmung von Rastergeschwindigkeit, Pulsparametern und dem genanntem Schmelzbadüberlapp bzw. dem Schraffurabstand, ein diskretes Abkühlen der einzelnen Schmelzlinsen oder Schweißperlen zu ermöglichen, und/oder den Energieeintrag durch den Aufschmelzstrahl zu optimieren. Dadurch werden insbesondere Abschnitte A wie anhand von Figur 2 illustriert, zuverlässig vor Überhitzungen geschützt.

## Patentansprüche

1. Verfahren zur pulverbett-basierten, additiven Herstellung eines Bauteils (10), umfassend das Festlegen von Bestrahlungsvektoren (Vh, Vc) für eine zu bestrahlende Schicht (L) für das Bauteil (10), wobei Bestrahlungsvektoren (Vh, Vc) unterhalb einer Länge von 1 mm in einem gepulsten Bestrahlungsbetrieb (pw) bestrahlt werden, wobei eine Pulsfrequenz unterhalb von 3 kHz und eine Scangeschwindigkeit unterhalb von 250 mm/s gewählt werden.

2. Verfahren gemäß Anspruch 1, wobei die Bestrahlungsvektoren Schraffurbestrahlungsvektoren (Vh) sind.

3. Verfahren gemäß Anspruch 1 oder 2, wobei Bestrahlungsvektoren (Vh, Vc) zwischen 1 mm und 2 mm Länge ebenfalls in einem gepulsten Bestrahlungsbetrieb (pw) bestrahlt werden, wobei eine Pulsfrequenz (f) oberhalb von 3 kHz und eine Scangeschwindigkeit (v) oberhalb von 250 mm/s gewählt werden.

4. Verfahren gemäß einem der vorhergehenden Ansprüche, wobei ein Schraffurabstand (a) der Bestrahlungsvektoren (Vh, Vc) derart gewählt wird, dass ein Überlapp von direkt benachbarten Bestrahlungsvektoren entsprechenden Schmelzbädern zwischen 30 % und 50 % beträgt.

5. Verfahren gemäß einem der vorhergehenden Ansprüche, wobei Bestrahlungsvektoren (Vh, Vc) ab einer Länge von ca. 2 mm in einem kontinuierlichen Bestrahlungsbetrieb (cw) bestrahlt werden.

6. Bauteil (10) hergestellt gemäß dem Verfahren nach einem der vorherigen Ansprüche, wobei das Bauteil für den Einsatz im Heißgaspfad einer Strömungsmaschine vorgesehen ist und mindestens einen dünnwandigen Abschnitt (A) aufweist.

7. Computerimplementiertes Verfahren zum Bereitstellen von Herstellungsanweisungen (Vh, Vc, f, a, v) für die additive Herstellung eines Bauteils (10), umfassend das Festlegen von Bestrahlungsparametern gemäß dem Verfahren nach einem der Ansprüche 1 bis 5.

8. Verfahren gemäß Anspruch 7, welches ein CAM-Verfahren ist.

9. Computerprogrammprodukt, umfassend Befehle, die bei der Ausführung eines entsprechenden Programms durch einen Computer (2) oder eine Steuerung der Bestrahlung in einer additiven Herstellungsanlage (100), diesen veranlassen, die Bestrahlungsparameter (Vh, Vc, f, a, v) gemäß einem der Ansprüche 1 bis 5 einzustellen.
